# EUROPEAN PATENT APPLICATION

(11) **EP 1 997 627 A1**
(43) Date of publication of application: **03.12.2008**
(21) Application number: 07425337.8
(22) Date of filing: 01.06.2007
(51) Int. Cl.: B41C 1/10, B23Q 3/18, G03F 7/20

(54) **Image forming device, in particular for printing litographic plates**

(71) Applicant: Andromeda S.r.l., 81020 S. Marco Evangelista (CE) (IT)
(72) Inventor: Enea, Roberto, 81100 Caserta (IT); Vannucci, Antonello, 00198 Roma (IT); De Giacomo, Luigi, 82026 Morcone (BN) (IT)
(74) Representative: Leone, Mario

(57) **Abstract**

Image forming device (1), in particular for printing lithographic plates suitable to be used in lithographic processes, allows the adoption of different exposure heads correctly positioned, with respect to the drum, by a respective interface member and comprises: at least one exposure head (3) having optical means acting on the surface of the photosensitive plate; and driving means for moving sad exposure head according to a predetermined direction, having a respective support system (7) for said exposure head (3); wherein said support system (7) comprises: a first supporting member (12); and an interchangeable second supporting member (14) apt to receive an exposure head (3) and to be associated to said first supporting member (12), the second supporting member (14) including adjustment means for the exposure head position (3).

## Description

The present invention is related to an image forming device, in particular in the field of printing lithographic plates suitable to be used in lithographic processes, wherein the image printed on the plate is transferred and reproduced on other media, using the plate as a master.

In known devices, the plate can be arranged on the outer surface of a rotating cylindrical drum, and one or more exposure heads are used for exposing the moving plate by means of optical means like a laser beam operating in the infrared field, in the ultra-violet field, in violet light field and with other wavelengths which may be considered suitable for this task.

The plates are coated with a layer sensitive to a light beams being projected on the surface of the plate, thereby achieving the image reproduction.

The exposure head is associated to driving means suitable for moving the head along a direction parallel to the drum axis, so as to cover the whole surface of the plate while it is rotated.

In the state of the art, several examples of driving means exist. In US 2004/0207711 A1 a handling system suitable for having simultaneously installed more than one exposure head is disclosed, each responsible for printing an image portion referencing to a predetermined colour. Such a system comprises means for translating said heads radially with respect to the drum.

The known systems do not have the required flexibility so as to mount heads operated with wavelengths different to each other, each of such heads requiring a suitable and peculiar adjustment system for the focus on the plate surface, and an appropriate system for positioning the head itself as well, system varying according to the head type.

Therefore, the known devices are generally used within only one filed of wavelength, and different image forming devices are used for exposing plates of respective different typologies.

The technical problem underlying the present invention is to provide an image forming device allowing to obviate to the drawbacks mentioned with reference to the prior art.

Such a problem is solved by a device as above specified, comprising:
* at least one exposure head having optical means acting on the surface of the photosensitive plate; and
* driving means for moving sad exposure head according to a predetermined direction, having a respective support system for said exposure head;
wherein said support system comprises a first supporting member and an interchangeable second supporting member apt to receive an exposure head and to be associated to said first supporting member, the second supporting member including means for the adjustment of the position of the exposure head.

The main advantage of the device according to the present invention lies in that it allows the adoption of different exposure heads, each referring to adjustment or focusing means of the device, but however correctly positioned, with respect to the drum, through the corresponding supporting member.

The present invention will be hereinafter disclosed according to a preferred embodiment thereof, provided to an exemplificative and non-limitative purpose with reference to the annexed drawings wherein:

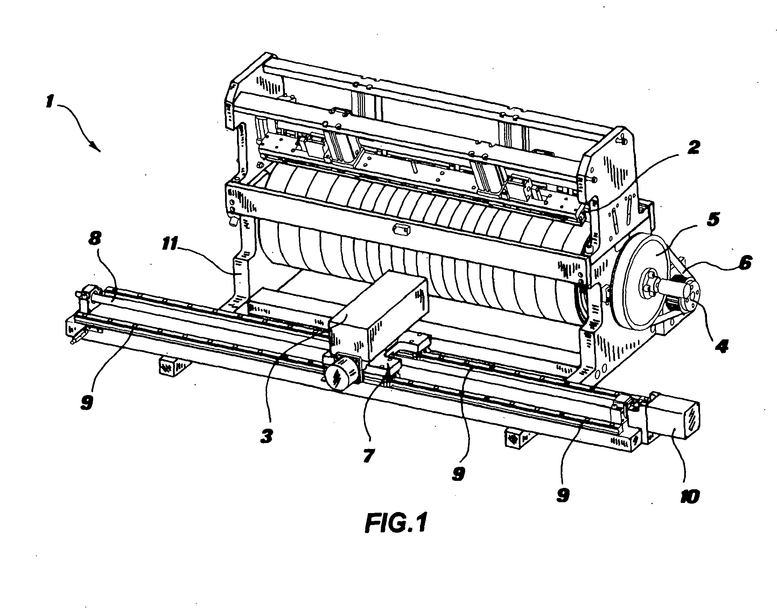

* Figure 1 shows a schematic and perspective view of an image forming device according to the invention;

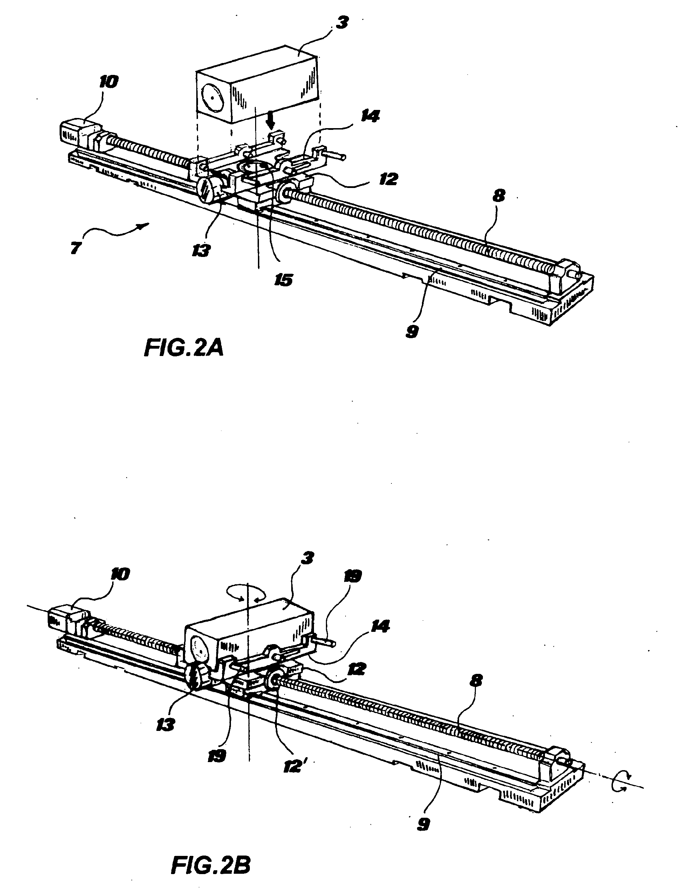

* Figures 2A and 2B show a perspective view of a detail of the device of figure 1;

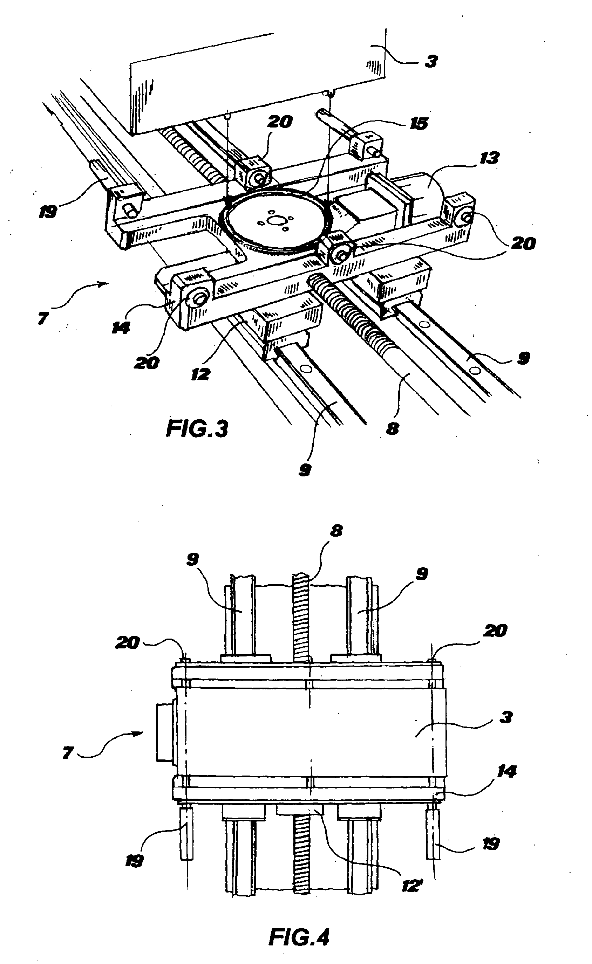

* Figure 3 shows an enlarged and partially exploded perspective view of a detail of the device of Figure 1;
* Figure 4 shows a top plan view of the detail of Figure 3;

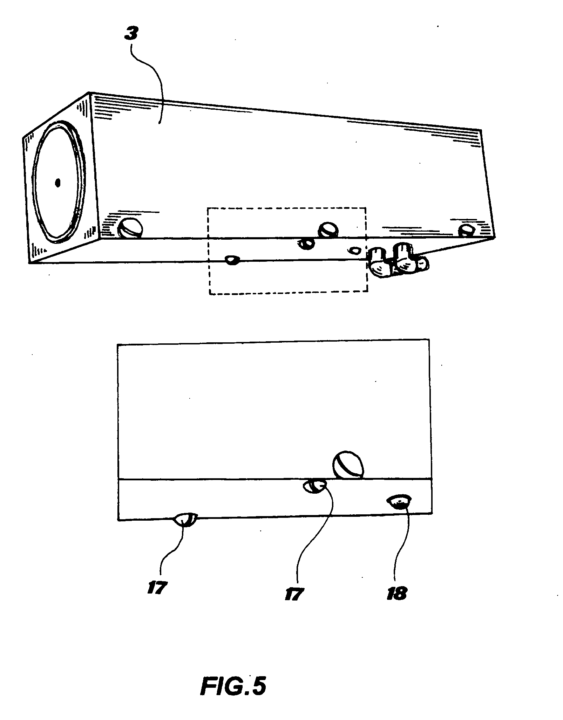

* Figure 5 shows a schematic perspective view illustrating the assembling of parts of the device of Figure 1;

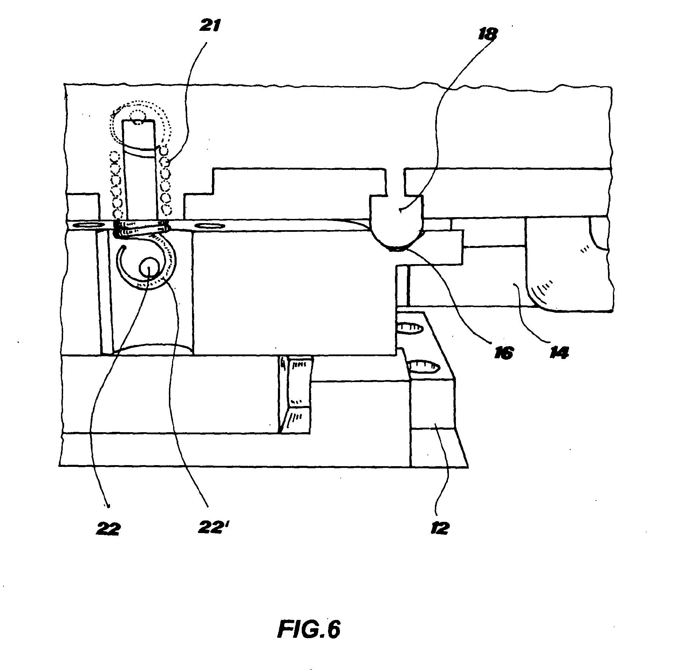

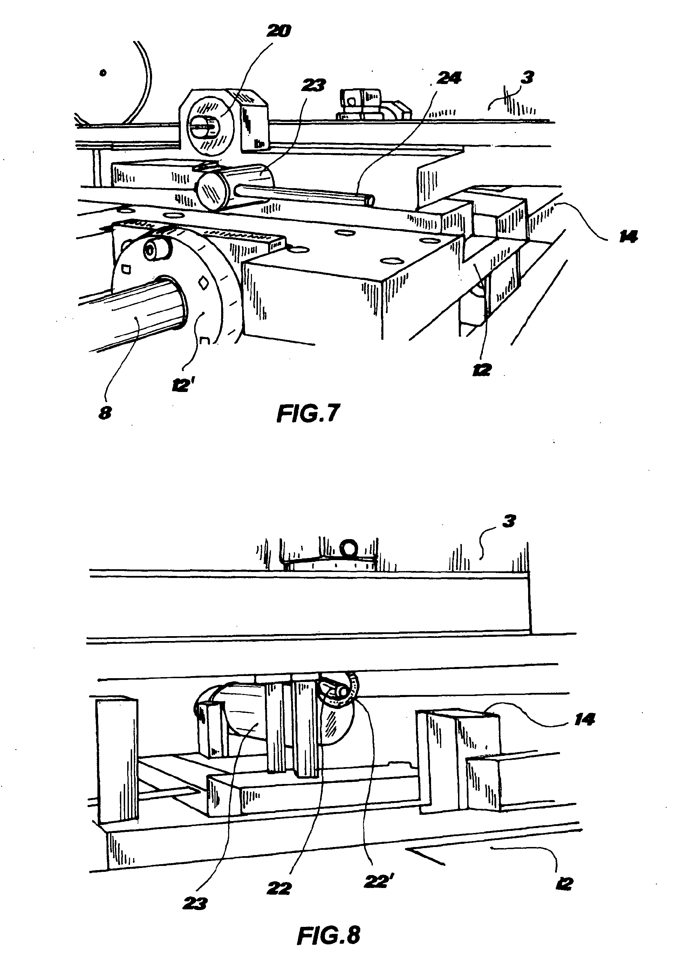

* Figures 6, 7 and 8 shows enlarged and partially sectioned perspective views of a further detail of the device of Figure 1.

With reference to the figures, an image forming device is partially represented and indicated as 1.

In the present embodiment, it comprises a cylindrical drum 2 on which a photosensitive plate, not shown, is arranged, which is engraved by an exposure head 3 laterally located with respect to the drum 2, and movable according to a direction parallel to the axis of the drum 2.

The device 1 comprises means for rotating the drum 2 at a predetermined rotation rate, depending upon the typology of the plate and upon the corresponding exposure head 3. A leading sheave wheel 4, connected to non-shown motor means, and a driven sheave wheel 5, integral to the drum 2, represent such means for rotating. The two sheave wheels 4, 5 are joined by a suitable belt 6.

The exposure head 3 is associated to driving means for moving said exposure head 3 according a direction parallel to the axis of the cylindrical drum 2.

Such driving means comprises a respective support system 7 for the exposure head 3. Such system is translated by an endless screw shaft 8 rotated by a motor 10 placed at one end of the lead screw shaft 8. The driving means also comprises straight guides 9 parallel to the axis of the drum 2.

The driving means and the drum 2 are supported by the same framework member 11 assuring the mutual distance thereof. Such framework member 11 is substantially formed in one piece.

In the following, longitudinal axis designates the axis of the exposure head 3 parallel to the axis of the drum 2; transverse axis designates the axis of the exposure head 3 perpendicular and intersecting the axis of the drum 2 - it substantially coincides with the optical beam projected on the photosensitive plate; and vertical axis designates an axis of the exposure head 3 which is perpendicular to a plane identified by the longitudinal and by the transverse axes.

The longitudinal axis, the transverse axis and the vertical axis form a Cartesian axis system fixed with respect to the framework member 11.

In the present embodiment, the exposure head 3 is intended to be translated, in a reciprocated motion, along a predetermined direction which is parallel to the axis of the cylindrical drum 2, i.e. the above mentioned longitudinal axis.

The support system 7 comprises a first supporting member embodied by a first supporting plate 12 on which said driving means operates. To this purpose, the first supporting plate 12 comprises a drive nut 12' fitted on said lead screw shaft 8, with a suitable internal thread formed therein to realize a lead-screw-nut mating.

On said first supporting member, adjustment means for the exposure means are arranged, generally indicated as 13, e.g. focusing means for the fine adjustment of the distance between the exposure head and the cylindrical drum surface, In particular, it can comprise an optics faced to the drum 2 so as to be feedback operated, thanks to a suitable connection (not shown), on the optics of the exposure head 3.

Said support system 7 further comprises a second interchangeable supporting member, complementary to said first supporting element and apt to receive a predetermined exposure head 3.

Specifically, for each kind of exposure head, a suitable supporting member is provided to receive the head, and hence adaptable to the size thereof, and to arrange that at a substantially correct distance from the drum 2, distance which can undergo a further adjustment.

The second supporting member is composed by a second supporting plate or counter-plate 14. Conventional fastening means are placed between the plate and the counter-plate.

On said counter-plate 14 or interface plate, means for the adjustment of the position of the exposure head 3 is provided.

Such means for the adjustment comprises a circular guide 15 formed on the resting surface of the counter-plate 14, on which the exposure head 3 is rested. Said circular guide 15 is arranged to receive pins projecting from the corresponding resting surface, i.e. from the lower surface, of the exposure head 3.

The circular guide 15 is embodied, in the present embodiment, by a groove 16 lowered with respect to the resting surface of the counter-plate 14. The cross-section of such a groove 16 is trapezoidal.

In the present embodiment, said pins comprises a pair of adjustment balls 17, vertically adjustable independently of each other and a fixed reference ball 18. The balls 17 and 18 can roll inside said groove 16.

However, it is intended that the circular guide can be carried out according to a different procedure, e.g. a projecting circular rail with vertically adjustable skids.

The means for the adjustment further comprises means for rotating the head 3 with respect to the vertical axis. It comprises micrometric translation members operating on a side surface of the exposure head, particularly at the proximal end thereof, i.e. the end close to the drum, and at the opposite distal end thereof.

The micrometric translation members are composed by micrometric screws 19 which can be manually or automatically adjusted.

Moreover, further fastening nuts 20 are provided on the opposite side surface of the head 3 with respect to said micrometric screws 19, and on both the side surfaces at an intermediate position.

Finally, the device 1 comprises blocking means of the exposure head 3 on the respective interchangeable supporting member.

In the present embodiment, the blocking means comprises an anchoring member 22 mobile between a locking position and a release position, and an elastic member 21 joined to the head 3.

The elastic member 21 is embodied by a helicoidal spring vertically extending through the second supporting member 14 in a suitable aperture. The free end 22' of the spring is engaged by said anchoring member 20 which is formed on one end of a circular section rod 23, which rotates by acting upon a suitable grip 24. The rod 23 longitudinally extends through a suitable seat of the second supporting member.

The anchoring member 20 longitudinally projects from the end of the rod 23 at an edge thereof: rotating the rod 23 of 180°, the anchoring member 20 is raised or lowered of a length corresponding to the actual thickness of the rod 23. The effective locking and the unlocking can be checked by the position of the grip 24 which is conveniently lever-shaped.

The opening of the elastic member 21 will be provided at the geometric centre of the circular guide 15, so as to allow the rotation of the head 3 with respect to the corresponding supporting member 14.

Once selected the exposure head which has to be operated in the image forming procedures, the operator can consequently select the respective supporting member to be fitted on the device 1, supporting member constituting the interface between device 1 and head 3.

At this point, the supporting member 14 is coupled to the receiving supporting element, thereafter the head 3 is positioned.

Operating separately on each or on only one of the adjustment balls 17, particularly on the height thereof, it is possible to carry out an angular adjustment with respect to the transverse axis of the device 1. Instead, operating simultaneously on said adjustment balls, it is possible to carry out an angular adjustment with respect to the longitudinal axis of the device 1.

Finally, acting on the micrometric screws 19, it is possible to carry out an angular adjustment of the head 3 with respect to the vertical axis of the device.

In this phase, the head rotates following the circular guide 15 without altering the preceding adjustments.

After having concluded the adjustment, it is possible to activate the blocking means, to prevent the head 3 to move in the operation of the device 1.

The adjustment of the positioning of the head 3 on the photosensitive plate arranged on the drum 2 is carried out by said means for the adjustment independent upon the supporting plate 14 of the head 3.

It is intended that a control system, not shown, manages the adjustments and the operation of the device 1. The adjustments related to the head 3 with respect to the longitudinal, transverse and vertical axes can be possibly power-assisted and driven through said control system.

To the above disclosed image forming device a man skilled in the art, to achieve further and contingent needing, can carry out additional changes and variants, all anyway embraced within the protection scope of the present invention, as defined by the annexed claims.

## Claims

1. Image forming device (1), in particular for printing lithographic plates suitable to be used in lithographic processes, comprising
* at least one exposure head (3) having optical means acting on the surface of the photosensitive plate; and
* driving means for moving sad exposure head according to a predetermined direction, having a respective support system (7) for said exposure head (3);
wherein said support system (7) comprises:
* a first supporting member (12); and
* an interchangeable second supporting member (14) apt to receive an exposure head (3) and to be associated to said first supporting member (12),
the second supporting member (14) including means for the adjustment of the position of the exposure head (3).

2. Device (1) according to claim 1, wherein the means for the adjustment comprises a circular guide (15) formed on the resting surface of the second supporting member (14) on which the exposure head (3) is rested.

3. Device (1) according to claim 2, wherein the circular guide (15) comprises a groove (16) provided to receive pins projecting from the corresponding resting surface, i.e. the lower surface, of the exposure head (3).

4. Device (1) according to claim 3, wherein said pins comprise balls (17, 18) apt to roll inside said groove (16).

5. Device (1) according to claim 4, wherein the means for the adjustment comprises a pair of adjustment balls (17), vertically adjustable independently of each other, and a fixed reference ball (18).

6. Device (1) according to claim 4 or 6, wherein the cross-section of such a groove (16) is trapezoidal.

7. Device (1) according to claim 2, wherein the means for the adjustment further comprises means for rotating the exposure head (3) with respect to a vertical axis.

8. Device (1) according to claim 7, wherein the means for rotating the exposure head (3) with respect to the vertical axis comprises micrometric translation members (19) operating on a side surface of the exposure head (3), particularly at the proximal end thereof.

9. Device (1) according to claim 8, wherein the micrometric translation members are composed by micrometric screws (19) which can be manually or automatically adjusted.

10. Device (1) according to claim 9, wherein the means for rotating the exposure head (3) with respect to the vertical axis comprises fastening nuts (20) on the opposite side surface of the exposure head (3) with respect to said micrometric screws (19), and on both the side surfaces at an intermediate position.

11. Device (1) according to claim 1, comprising blocking means of the exposure head (3) on the respective interchangeable supporting member (14).

12. Device (1) according to claim 11, wherein the blocking means comprises an anchoring member (22) mobile between a locking position and a release position, and operating on an elastic member (21) joined to the exposure head (3).

13. Device (1) according to claims 2 and 12, wherein the elastic member (21) is composed by a helicoidal spring vertically extending through the second supporting member (14) in a suitable aperture at the centre of said circular guide (15).
